Europäisches Patentamt

European Patent Office

Office européen des brevets

(11) Publication number: **0 337 078**
**A2**

## EUROPEAN PATENT APPLICATION

(21) Application number: **89102647.8**

(22) Date of filing: **16.02.89**

(51) Int. Cl.⁴: **H03K 19/017**

(30) Priority: **11.04.88 US 179794**

(43) Date of publication of application:
**18.10.89 Bulletin 89/42**

(84) Designated Contracting States:
**DE FR GB**

(71) Applicant: **HONEYWELL INC.**
**Honeywell Plaza**
**Minneapolis Minnesota 55408(US)**

(72) Inventor: **Fulkerson, David E.**
**16500 Eagle Ridge Drive**
**Minnetonka Minnesota 55345(US)**

(74) Representative: **Rentzsch, Heinz et al**
**Honeywell Europe S.A. Holding KG Patent &**
**License Dept. Postfach 10 08 65**
**Kaiserleistrasse 39**
**D-6050 Offenbach am Main(DE)**

(54) **High speed logic circuit.**

(57) An improved FET capacitance driver logic circuit
has an inverter feedback stage (22) connected from
the output to the input of an output FET (23) to allow
the output FET to have a large capacitance charging
current surge followed by a reduced conduction
thereafter.

FIG.1

EP 0 337 078 A2

# HIGH SPEED LOGIC CIRCUIT

The present invention describes an improvement of the invention of earlier EP-A-0 296 508 published December 28,1988. It is directed to the field of logic design improvements, particularly to the problem of reducing gate delay due to capacitance. The circuit described in said earlier application has several advantages over the previously known circuits. These advantages are described in said earlier EP-A-0 296 508. It is the main object of the present invention to prevent current in the output stage. This is achieved by the invention as characterized in the independent claims. Preferred improvements are described in the dependent claims.

The invention will not be explained with reference to a preferred embodiment as shown in the drawings, where:

Figure 1 is a generalized circuit diagram showing the invention and

Figures 2a to 2e show variations of particular portions of Figure 1.

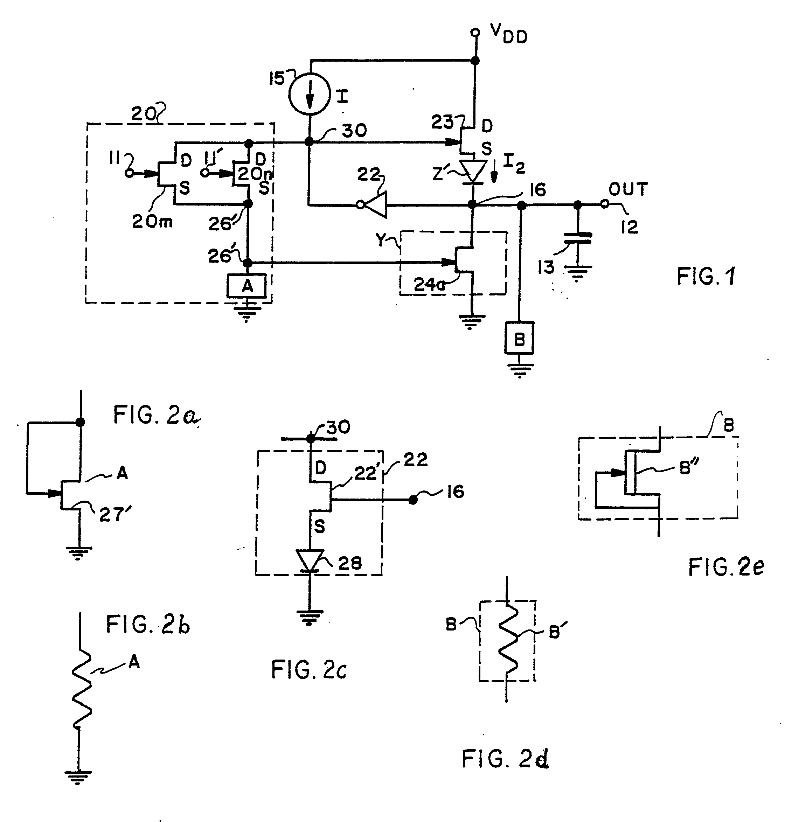

The logic circuit of Figure 1 has two input terminals 11 and 11' connected to the gate electrodes of FETs 20m and 20n. The circuit includes a plurality of FETs 20m, 20n, 23, 24a, together with a further FET 27' when the variation of Fig. 2a is used, or with a further FET when the inverter of Figure 2c is used. Input 11 is connected to the gate electrode of FET 20m. Input 11' is connected to the gate electrode of FET 20n. The source electrodes S of FET 20m and 20n are connected to a terminal 26' and then through an impedance element A to ground. FET's 20m and 20n together with impedance A constitute a signal translator 20 as described in earlier EP-A-0 296 508. Terminal 26' is also connected to the gate electrode of a FET 24a. The drain electrode D of FETs 20m and 20n are connected to the output terminal 30 of current source means 15. When one of the FETs 20m and 20n is conducting the resulting voltage at 26' developed across impedance A is sufficient to turn on pull-down FET 24a. The voltage source $V_{DD}$ is connected throught the drain-source circuit of FET 23, the impedance shown as diode Z', the junction 16, and the drain-source circuit of FET 24a to ground. An impedance B is also shown in parallel with FET 24a from junction 16 to ground and therewith also in parallel with capacitor 13.

In Figure 2a the impedance A of Figure 1 is shown in the form of a diode connected FET 27'. The impedance A may also take the form of a resistor as shown in Figure 2b. In Figure 2c, the inverter 22 shown more generally in Figure 1, is shown as a FET 22' and diode 28 in which the terminal 16 is connected to the gate of FET 22', the drain D being connected to terminal 30 and to the gate of FET 23, and the source S being connected to ground by way of diode 28. In Figure 2d the impedance B of Figure 1 is shown as a resistor B' while in Figure 2e the impedance B is shown as a diode-connected depletion FET B''.

In this preferred embodiment of Figure 1, in connection with 2a and 2c the operation is as follows; assume an initial condition in which inputs 11 and 11' are low so that FETs 20m and 20n are "off". No current then flows from the current source 15 through these FETs 20m and 20n and only a small potential exists across impedance A so that FET 24a is also "off". In this initial condition the FET 23 was first highly conductive by the bias from current source 15 and rapidly charged the capacitance 13, the output voltage at terminal 12 rising rapidly. The inverter 22, actually FET 22' and diode 28, are initially nonconductive and provide a high impedance between terminal 30 and ground, however, as the output voltage rises rapidly a threshold voltage is reached at which FET 22' and diode 28 (i.e., the inverter) become conductive and carry the current from current source 15 through the drain-source of FET 22' and diode means 28 to ground. The result is that the voltage at terminal 16 is limited, the previously highly conductive voltage pull-up FET 23 now becomes substantially nonconductive supplying only the current needed by the impedance B, and any output load current. The only FET conducting any substantial amount of current at this point is the inverter FET 22'. Thus the circuit is effective to initially fully turn on FET 23 to provide a rapidly rising output voltage, quickly charging the parasitic capacitance 13 and reducing the gate delay; and then by the action of inverter circuit 22 turning off (substantially) the FET 23.

Assume input 11 or 11' goes high so that one of FETs 20m and 20n is on. The resulting voltage drop across impedance A is effective to also turn on FET 24a. With one of these FETs 20m and 20n conducting it is effective to sink all of the current I so that the voltage at 30 is low. FET 23 is thus biased off and $I_2$ is zero or nearly so. Conductive FET 24a rapidly discharges the capacity 13 reducing the output potential at 16, 12 to a low value. The conductive FET 24a has to sink virtually no current subsequent to initially discharging capacitance 13. The output at 12 is low.

The inverter means 22 has been several times recited as being coupled or connected from junction 16 to the gate of FET 23, so that the initially full on FET 23 can be cut back by inverter means 22 as soon as the output voltage (at 12 and 16) reaches the desired level, in this case the threshold voltage of FET 22'. The important function is that the signal of the inverter mean is coupled to cut back the conduction of FET 23 and this coupling may include a more indirect circuit route as well as the direct connection to the gate which is shown.

## Claims

1. A FET logic circuit comprising:

a) a first FET (23) having a gate electrode and an output circuit comprising drain and source electrodes; output circuit means (16, 12) comprising said output circuit interconnecting a source of voltage ($V_{DD}$) and a logic output terminal, said first FET when conductive operating as a voltage pull-up device for said output terminal (12);

b) a second FET (24a) having a gate electrode and output electrodes comprising drain and source electrodes, said output electrodes interconnecting said logic output terminal (16, 12) and a voltage reference (ground);

c) current means (15) having terminals including an output terminal (30), said current means output terminal (30) being connected to the gate electrode of said first FET (23);

d) a third FET (20m) having a gate electrode and output electrodes comprising drain and source electrodes, said third FET having its output electrodes and a serially connected impedance means (A) interconnecting said current means output terminal (30) and said reference (ground), said impedance means being between said voltage reference and said FET, said third FET having its gate electrode for connection to a signal source (11) for controlling the conductivity of said third FET;

e) connection means (26') from the gate electrode of said second FET (24a) to said impedance means (A);

**characterized by**

f) inverter means (22) having a control terminal and output terminals, said control terminal being connected to said logic output terminal (12, 16) to sense the voltage level at said logic output terminal, said inverter means (22) having one (D) of its output terminals coupled to said first fET (23) gate electrode and the other of its output terminals to said voltage reference (ground), said inverter means having a sensed voltage threshold at said control terminal at which said inverter means couples to said first FET gate electrode a signal to limit the pull-up to said threshold level.

2. The circuit according to claim 1, **charaterized by** diode means (Z') in said output circuit means serially connected with said first FET output circuit (S, 16), said diode means being between said logic output terminal (12, 16) and said first FET (23).

3. A FET capacitance driver logic circuit subject to capacitance of a logic output terminal, which capacitance tends to delay switching time at the logic output terminal, the circuit comprising:

a) a plurality of FETs (23, 24a, 20m, 22'), each having a gate electrode and drain and source output electrodes; a first of said FETs (23) having its output electrodes and a serially connected first diode means (Z') interconnecting a source of voltage ($V_{DD}$) and a logic output terminal (16), said diode (Z') being between said logic output terminal (16) and said FET (23);

b) a second of said FETs (24a) having its output electrodes interconnecting said output terminal (12) and a voltage reference (ground);

c) a current means (15) having terminals including an output terminal (30), said current means output terminal being connected to the gate electrode of said first FET (23);

d) a third of said FETs (20m) having its output electrodes and a serially connected impedance means (A) interconnecting said current means output terminal (30) and said reference (ground), said impedance means (A) being between said voltage reference and said FET, said third FET having its gate electrode for connection to a signal source (11) for controlling the conductivity of said third FET;

e) connection means from the gate electrode of said second FET (24a) to said impedance means (A);

**characterized by**

f) a fourth of said FETs (22') having its output electrodes and a serially connected second diode (28) interconnecting said current means terminal (30) and said voltage reference (ground), said second diode (28) being between said voltage reference and said fourth FET, said fourth FET having its gate electrode connected to said logic output terminal (16).

4. A FET capacitance driver logic circuit subject to an inherent capacitance of a logic output terminal, which capacitance tends to delay switching time at the logic output terminal, the circuit comprising:

a) a first power terminal ($V_{DD}$) for energization by a source of potential;

b) a diode (Z');

c) first (23) and second (24a) GaAs FETs each having a source electrode, a drain electrode and a gate electrode, the first FET drain electrode (D) being connected to said first power terminal ($V_{DD}$), said first FET source terminal (S) being connected through said diode (Z') to a logic output terminal (16) and to the drain electrode of said second FET (24a), the source electrode of said second FET being connected to a voltage reference (ground);

**characterized by**

d) a third GaAs FET (22′) having its gate electrode connected to said logic output terminal (16), its drain electrode (D) connected to said first FET (23) gate electrode and its source electrode (S) connected by way of a second diode (28) to said reference (ground);

e) impedance means (A);

f) a fourth GaAs FET (20m) having its gate electrode connected to a signal input terminal (11), its source electrode connected to said reference (ground) by way of said impedance means (A) and having a drain electrode;
the gate electrode of said second FET (24a) being connected to said impedance means (A);

g) a current means (15) having terminals including an output terminal (30) connected to said first FET (23) gate electrode, said third FET (22′) drain electrode and said fourth FET (20m) drain electrode; and

h) a second impedance means (B) connected between said logic output terminal (16) and said reference (ground).

5. The circuit according to claim 3, **characterized by** a fifth (20n) of said enhancement type FETs having its output electrodes connected in parallel with the output electrodes of said third FET (20m), said fifth FET (20n) having its gate electrode for connection to another signal source (11′) for controlling the conductivity of said fifth FET (20n), said impedance means (A) thus being in series with the paralleled output electrodes of said third (20m) and fifth (20n) FETs.

6. The circuit according to claim 4, **characterized by** a fifth enhancement type FET (20n) having its source and drain electrodes connected in parallel with the source and drain electrodes of said fourth FET (20m), said fifth FET (20n) having its gate electrode for connection to another signal input source (11′) for controlling the conductivity of said fifth FET, said impedance means (A) thus being in series with the paralleled source and drain electrodes of said fourth and fifth FETs.

7. The circuit according to one of the preceding claims, **characterized in that** said first (A) and/or second (B) impedance means is a resistor.

8. The circuit according to one of the claims 1 to 6, **characterized in that** said first (A) and/or second (B) impedance means is a sixth FET (27′, B″) having its gate electrode connected to one of its output electrodes.

FIG.1

FIG. 2a

FIG. 2b

FIG. 2c

FIG. 2d

FIG. 2e